(19) Europäisches Patentamt
European Patent Office
Office européen des brevets

(11) **EP 1 855 379 B1**

(12) **EUROPEAN PATENT SPECIFICATION**

(45) Date of publication and mention
of the grant of the patent:
**09.02.2011 Bulletin 2011/06**

(51) Int Cl.:
***H03F 1/30*** *(2006.01)*

(21) Application number: **06425321.4**

(22) Date of filing: **12.05.2006**

(54) **Output power control of an RF amplifier**

Ausgangsleistungskontrolle eines Hochfrequenzverstärkers

Commande de puissance de sortie d'un amplificateur haute fréquence

(84) Designated Contracting States:
**DE FR GB IT**

(43) Date of publication of application:
**14.11.2007 Bulletin 2007/46**

(73) Proprietor: **STMicroelectronics Srl**
**20041 Agrate Brianza (MB) (IT)**

(72) Inventors:
• **Vaiana, Michele**
**95047 Paterno (IT)**
• **Gramegna, Giuseppe**
**95131 Catania (IT)**

(74) Representative: **Pellegri, Alberto et al**
**Società Italiana Brevetti S.p.A.**
**Via Avegno, 6**
**21100 Varese (IT)**

(56) References cited:
EP-A1- 1 326 328    EP-A2- 0 609 053
EP-A2- 0 942 524    US-A1- 2002 024 390
US-A1- 2004 056 721    US-A1- 2005 068 107
US-B1- 6 271 695    US-B1- 6 304 108

• JARVINEN, E.; KALAJO, S.; MATILAINEN, M.: "Bias circuits for GaAs HBT power amplifiers" MICROWAVE SYMPOSIUM DIGEST, 2001 IEEE MTT-S INTERNATIONAL, vol. 1, 20 May 2001 (2001-05-20), pages 507-510, XP002405191 Phoenix , AZ

**Description**

BACKGROUND

Field of the invention

The present invention relates to sensing and control of the output signal power of an electronic amplifier and in particular for radio frequency (RF) power amplifiers.

Discussion of related art

The demand of power amplifier for wireless handset is growing at rapid rate. Communication standards such as GSM, EDGE, and DCS require precise output power control of the power amplifier (PA), generally a current controlled bipolar transistor, for example a BJT or a HBT, in order to improve signal to noise ratio of receiver channels and, at the same time, increase talk time and battery life by reducing power consumption of the transmitter.

Moreover, overall system efficiency of GSM/EDGE transmitter can be increased by using polar architectures [1]. In this case, bias circuits to control the PA output power, with large dynamic range and no degradation on efficiency and linearity, have to be designed in order to comply with system specifications.

An example for such a bias circuit is given in EP 1 326 326.

***Voltage Limited Mode***

The output power of a high efficiency PA can be expressed in terms of the supply voltage *Vcc* as:

$$P_{OUT} = k_V \cdot \frac{(V_{CC} - V_{CESAT})^2}{R_{LOAD}} \qquad \textbf{Equation 1}$$

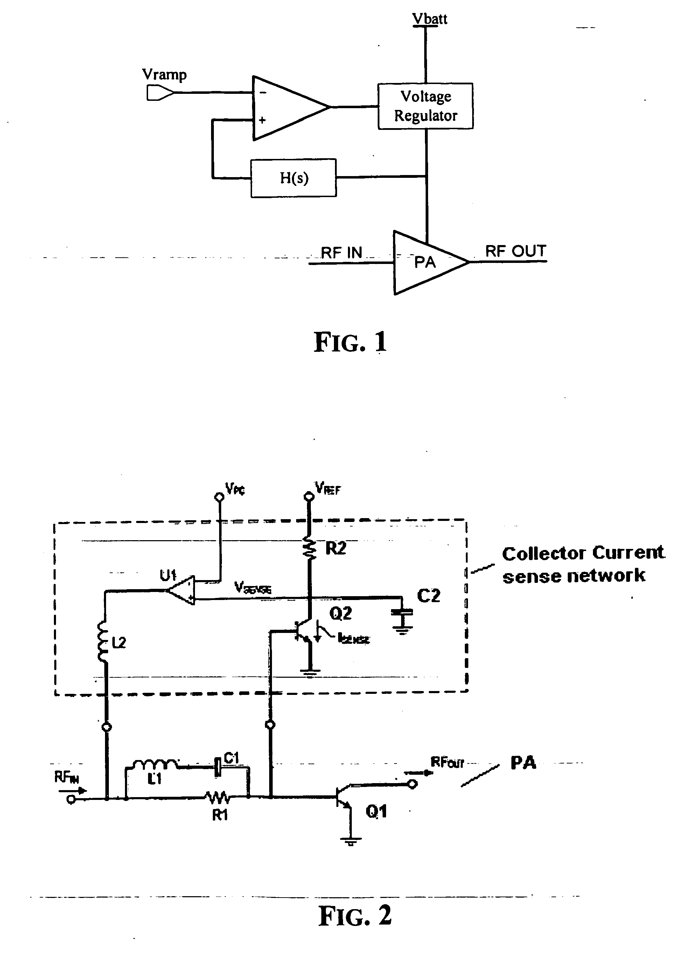

Where *Rload* represents the load resistance and $k_V$ is a scale factor function of the class of operation of the power amplifier. Thus, as well as in AM modulators [2], a linear in dB regulation of the output power can be obtained by varying the supply voltage *Vcc*, using a linear voltage regulator [3] in order to control the PA output power. A simplified implementation of this solution is depicted in Figure 1.

At low power levels, when *Vcc* approach $V_{CESAT}$, accuracy of the power control is limited due to the inability to compensate $V_{CESAT}$ and non-linear effects of temperature variations. Power dynamic range is then limited between the maximum supply voltage, usually fixed by the application and the power device ruggedness, and a minimum supply voltage, close to $V_{CESAT}$ of the power transistor.

An extended high accuracy range can be obtained if a power control feedback is introduced between the PA and the voltage regulator in order to compensate output power variation due to temperature changes. In this case, a directional coupler and power detectors can be used to close the feedback loop with the drawbacks of an increased insertion loss along the transmit channel and a cost increase of the device because of the additional silicon area required. Moreover, stability of the closed-loop must be ensured at every power level and load condition.

***Current Limited Mode***

It's well known that in high efficiency power amplifiers, functioning in discontinuous conduction mode, the output power is a function of collector current of the bipolar power device. Thus, an enhanced output power dynamic range and accuracy of control can be obtained by sensing and limiting the output current of the PA.

In this case, the amplifier operating mode becomes a current-limited operation mode in which Equation 1 no longer holds and Pout is given by the following equation:

$$Pout = k_C \cdot Iout^2 \cdot R_{LOAD} \qquad \textbf{Equation 2}$$

In bipolar technology amplifiers, collector current is a function of the base current and therefore of the base-emitter voltage applied to the transistor. An example of prior art solution [4], with no extra losses and requiring a relatively small amount of additional device area, that makes use of the relationship between output power and base-emitter voltage is depicted in Figure 2. The supply voltage *Vcc* may be supposed constant. A sense transistor that may also be a bipolar transistor but that may even be a field effect transistor, is realized as close as possible to the output power transistor in order to generate the current *Isense,* a scaled replica of the DC current drawn by the power transistor that is then converted in and *Vsense.* The voltage *Vsense* is AC shunted to ground while to DC component is fed to the non inventing input of the error amplifier U1.

The output of the error amplifier U1 is connected to the base terminal of the power transistor and, thanks to the negative feedback loop, controls the DC collector current of the bipolar power transistor. Being the PA output power proportional to the DC collector current, control of the output power is actuated by varying a power control voltage *Vpc.* Current limited mode is then obtained by controlling the base-emitter voltage of the power transistor at constant *Vcc* voltage.

A similar current sensing cell employed in a feedback bias control circuit is described in E. Jarvinen "Bias Circuits for GaAs HBT Power Amplifiers," 2001 IEEE MTT-S Digest, pp 507-510 [5].

However, in both these known solutions, the current *Isense* (or *Im*) can be assumed to really represent a scaled replica of the DC current of the power bipolar junction transistor only if the sense and the power transistor have same temperature, same base-emitter voltage and same AC load.

These conditions hardly exist in case of an AC grounded load of the sense transistor. Therefore, mismatches will occur between the collector currents of the power and of the sense transistor due to a high harmonic content of collector voltage and current waveforms. Once the AC load termination of the power transistor has been fixed, a two step calibration procedure will be necessary: output power versus collector current of the power transistor first, and secondly collector current versus the current *Isense* (i.e. the voltage *Vsense*) of the sense transistor. In practice, these mismatches limit the field of application of the circuital arrangement proposed in [4] to linear power amplifiers or to saturated amplifiers of limited range of accuracy.

OBJECTIVE AND SUMMARY OF THE INVENTION

In line with the above discussed known current limited mode approaches in implementing an accurate control through a broad dynamic power range of a high efficiency power amplifier functioning with non-continuous conduction, the applicants have found a way of significantly enhancing the precision and reliability of the control practically overcoming the above discussed limitations and weaknesses of the known circuits.

Basically, a current limited mode of operation is implemented by sensing the base current of the output power transistor and comparing it with a certain control current that is normalized by scaling it in function of the current gain ($\beta$) of a bipolar junction transistor of similar characteristics of the output power transistor. This has been found to ensure an outstanding precision and robustness of the control by effectively compensating for the fabrication process spread of current gain figures of bipolar junction transistors. Moreover, by employing a band-gap temperature compensation control current that is eventually $\beta$-scaled before comparing it with the sensed base current of the output power transistor, the output power may be effectively controlled and maintained constant over temperature as well as process spread variations.

According to this invention, the sense transistor of the sense network of the base current of the output power transistor is coupled as an emitter-follower to the base node of the output power transistor for sensing the base current of the output transistor.

A control current generator, preferably a band-gap temperature compensated current generator, forces a temperature compensation control current through a bipolar junction transistor of similar characteristics of the output power transistor, and a divider circuit by the current gain ($\beta$) of the bipolar junction transistor produces a $\beta$-scaled base current that is compared with the sensed base current of the output power transistor.

The two currents to be compared are converted to voltage signals on respective current-to-voltage converting networks and the corresponding voltage signals are applied to respective input nodes of the error amplifier of the control loop. In function of the output signal of the error amplifier, an input biasing network maintains the DC base current of the output power transistor equal to the $\beta$-scaled control current or limit the maximum DC base current of the output power transistor to the same value.

The invention is defined in claims 1 and 6 and particularly effective embodiments are defined in the remaining claims.

BRIEF DESCRIPTION OF THE DRAWINGS

Figure 1, as already discussed above, is a known output power control circuit.

Figure 2, as discussed above, is a known output power control circuit, using a sense transistor for monitoring the output transistor collector current.

Figure 3, shows the basic diagram of the circuit of output power control of this invention.

Figures 4 and 5 show the spread of current gain figures (β) versus input power, without and with β-scaling of the control circuit, respectively.

Figure 6 shows a circuit for β-scaling a certain control current.

Figure 7 shows an embodiment of the control circuit of this invention.

Figure 8 is a detail diagram of the control circuit of Figure 7;

Figure 9 shows an alternative embodiment of the control circuit of this invention;

Figure 10 shows curves of regulation of the output power in function of the control current input.

DESCRIPTION OF THE EMBODIMENTS OF THE INVENTION

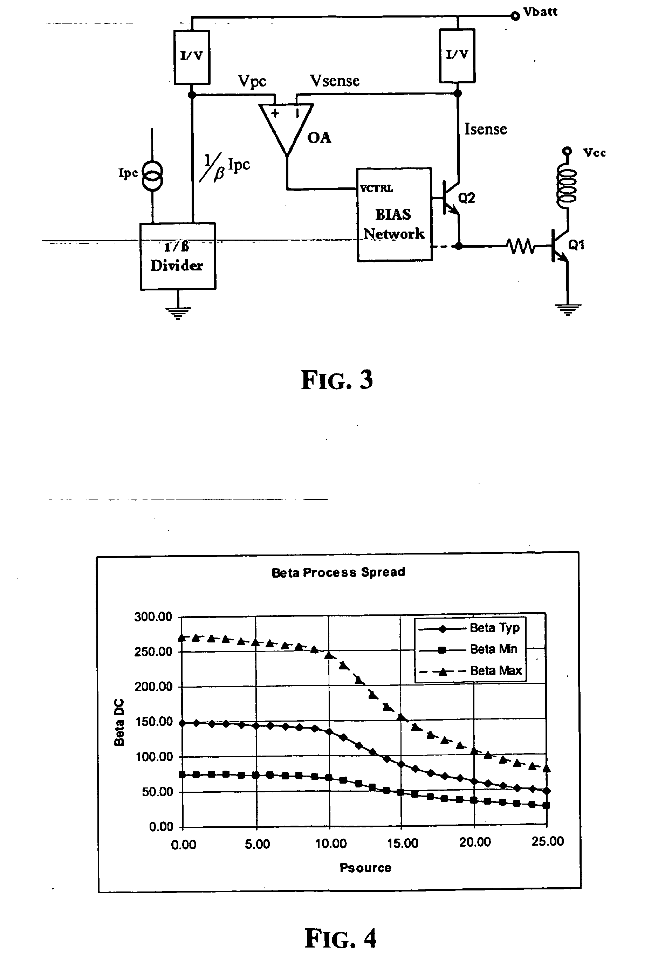

A basic diagram of the proposed power control bias circuit of this invention is shown in Figure 3.

According to a fundamental aspect of this invention, the base current of the power bipolar transistor Q1 is sensed by the use of an emitter follower sense transistor Q2.

The base current sensed by Q2 is converted by an I/V block and the resulting voltage signal *Vsense* is compared by the error amplifier OA with a power control signal V*pc*. The *Vpc* signal is produced by similarly converting a β-scaled control current *1/β Ipc*. A control current generator generates a *Ipc* that is then divided by the circuit block, *1/β Divider*, by the current gain (β) of a bipolar junction transistor of the same type of the output transistor Q1 to produce a β-scaled control circuit *1/β Ipc.* The error signal, output by the OA, drives the input control signal, *Vctrl,* of a biasing network.

Depending on the arrangement of the biasing network, the negative feedback loop that closes itself through the transistor Q2, the error amplifier OA and the biasing network maintains the DC base current of the output power transistor Q1 equal to I/β *Ipc* or limit the maximum DC base current to the same value *I/β Ipc.*

Moreover, being the sensed base current of Q1 compared to a β-scaled replica of the control current *Ipc*, if a band-gap temperature compensated control current *Ipc* is used, the collector current of the output power transistor Q1 can be controlled and maintained constant over temperature and process spread variations.

Thus, the output power of the PA can be controlled in a current limited mode of operation by varying the control current *Ipc.* Once the regulation law is determined, the relationship between the output power and the base current is established with a single step calibration procedure. This may include trimming the mirroring ratio of the β-scaled replica of the control current *Ipc* onto the respective I/V block at the input of the error amplifier OA.

The power control circuit of this invention drastically reduces sensitivity to process spread variations of the current gain of bipolar junction transistors because the control current that is compared with the sensed base current of the output power is normalized by β-scaling it.

In high efficiency non linear amplifiers working under large signal conditions, it may be objected the fact that while the output power transistor may exhibit a substantial compression of its β caused by an enhanced effect of non linearities under large signal conditions while the β scaling that, according to this invention is operated by the block *1/β Divider* on the control current remains performed at DC bias level even under large signal conditions, and therefore a mismatch or a significative deviation from the established regulation law should occur. However, this has revealed not to represent a real problem or drawback of the novel approach of the applicants.

Indeed, it has been found that such a recognizable deviation of the respective β scalings of the collector current of the output power transistor that is sensed as base current of the output transistor itself, and of the control current, on which a β scaling is performed at DC bias level, can be practically and effectively compensated when establishing the most appropriate regulation law through a single circuit trimming operation, practically by adjusting the mirroring ratio of the β-scaled control current onto the relative I/V network from which the reference signal of the error amplifier of the control loop is derived.

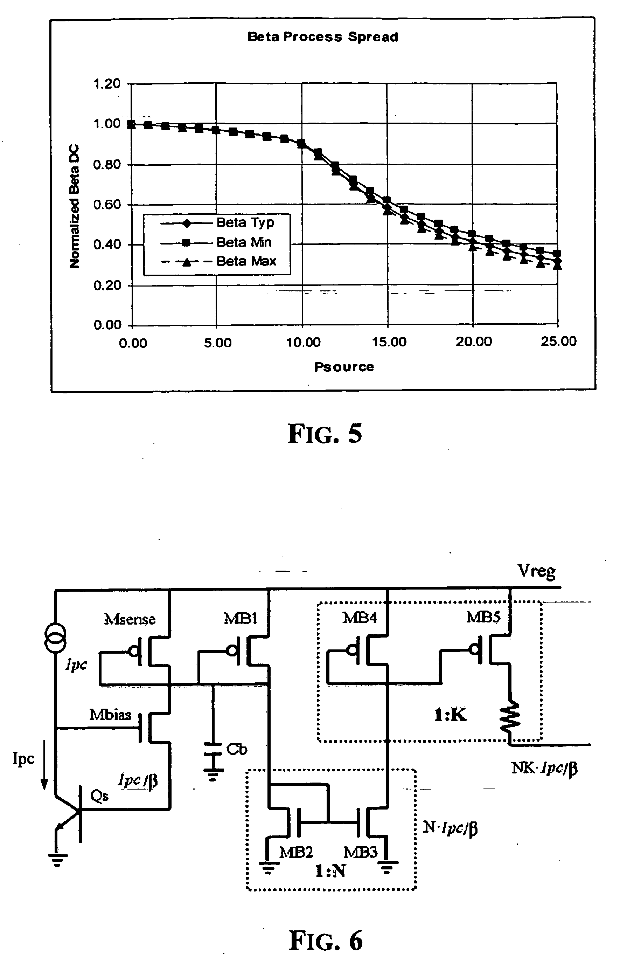

This can be observed from the β compression characteristics (ratio between DC collector and base current) of the bipolar output power transistor versus input signal power *(Psource)* over process spread variations depicted in Figures 4 and 5.

By normalizing each β curve by its maximum value, process spread variations have the same level of compression versus source power. Thus, comparison between a β-scaled control current, *1/β Ipc,* and the sensed base current *Isense* of the output power transistor Q1 allows to maintain a high accuracy of control of the output power of the PA versus temperature and process spread variations.

An example of a suitable β-Divider circuit is shown in Figure 6. A control current $I_{Qs}$ is forced through a bipolar transistor Qs of the same type of the output power transistor and its base current is mirrored on the MOS transistor Msense. The current $I_{Qs}$ is eventually multiplied by a current mirror for providing a β-scaled replica of the Qs base current of correct magnitude that is the β-scaled current is thereafter multiplied by the mirroring ratio 1/N of a first mirror MB2-MB3 and then by the mirroring ratio 1/K, of a second mirror MB4-MB5 to produce a β-scaled control current $NK(I_{Qs}/\beta)$. Most preferably, the two mirroring ratios are adjustable during testing on wafer of the devices being fabricated in order to trim the regulation characteristic of the control loop.

Referring back to the basic circuit of Figure 3, being *Isense* equal to the collector current of the PA output transistor Q1, divided by its current gain (β), and compared to *1/β Ipc,* that is to a β-scaled replica of the collector current of a bipolar transistor Qs of the same type of Q1, once the appropriate regulation characteristic curve is determined it will be maintained over β process spread variations.

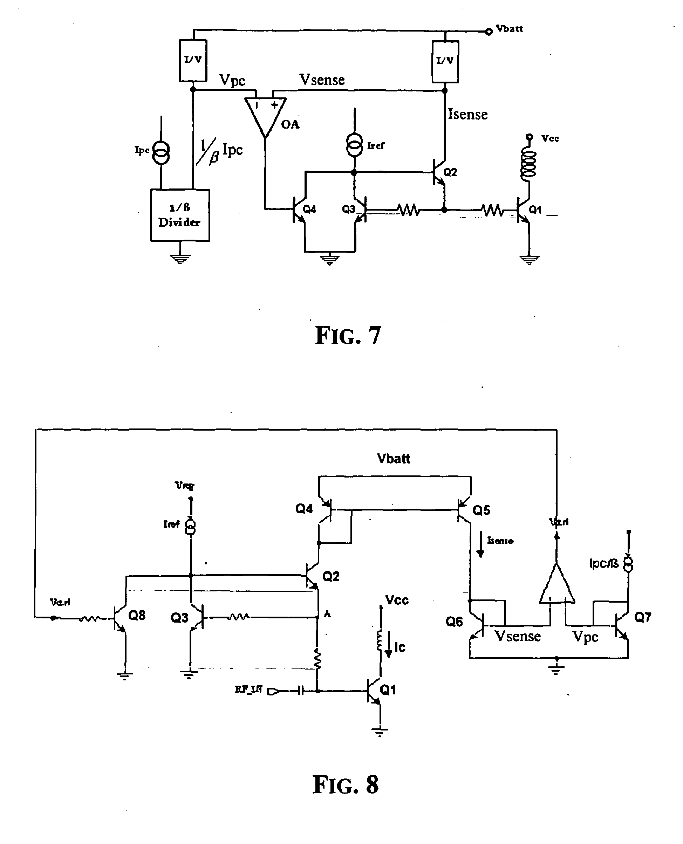

Figure 7 shows an embodiment in which an open collector transistor is used to close the feedback loop between the sense transistor Q2 and the OA. In this case, if the base current of the output power transistor Q1 is lower then the β-scaled replica of the control current *1/β Ipc,* transistor Q4 of the differential pair $Q_4$-$Q_3$ is open and the bias currents are fixed by the biasing current generator *Iref.* If the base current of Q1 becomes higher then *1/β Ipc,* the OA of the feedback loop will reduce the base current of Q 1 fixing is value to *1/β Ipc.* A correspondent detailed circuit is shown in Figure 8.

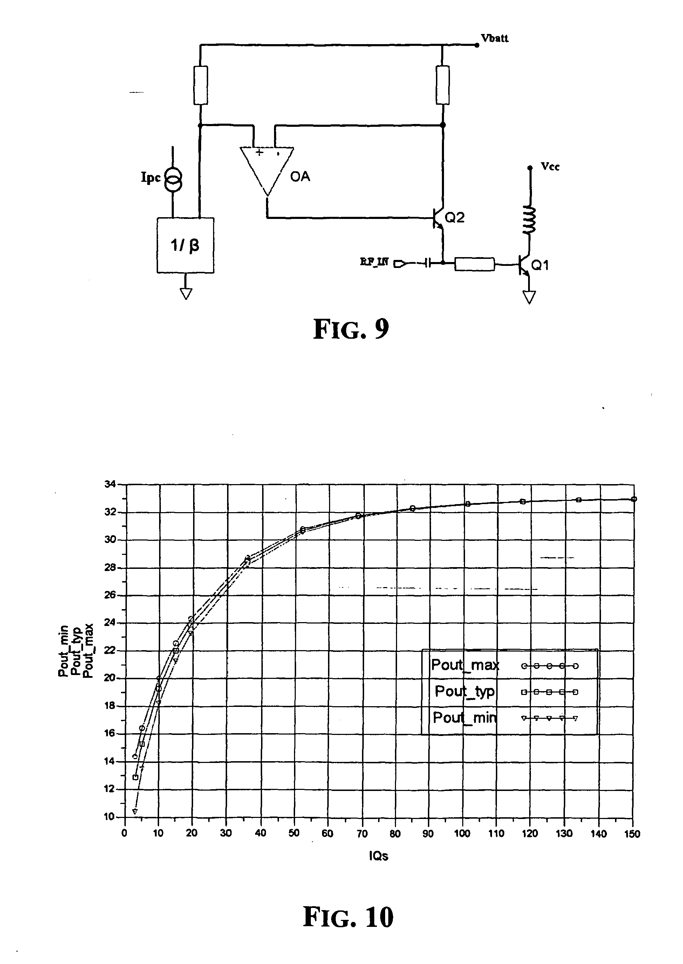

According to the alternative embodiment of Figure 9, the feedback loop is instead always active and therefore will fix the base current of the output power transistor Q1 to a constant value equal to *1/β Ipc* over temperature, process spread and input power variations.

An example of output power regulation of a PA amplifier at constant supply voltage is reported in Figure 10. 19dB of dynamic range can be achieved with ±1dB of accuracy versus process spread and temperature variations.

**REFERENCES**

[1] Earl McCune "Polar modulation and bipolar RF power devices", BCTM Conferences 2005

[2] R. A. Heising, "Modulation Methods," Proceedings of the IEEE, May 1962, pp. 896-901

[3] D. Epperson et al. " Power Amplifier Control Circuit, " US Patent, 6,853,250 July 16, 2003

[4] S. P. Bachhuber et al. "Amplifier Power Control Circuit, " US Patent, 6,853,250 March 31, 2005

[5] E. Jarvinenn "Bias Circuits for GaAs HBT Power Amplifiers," 2001 IEEE MTT-S Digest, pp 507-510

[6] G. Gramegna et al." Precision low-noise current mode biasing scheme for BJT with inductive emitter degeneration, "US. 6,271,695

**Claims**

1. A control circuit for sensing and controlling the output current of a bipolar transistor power amplifier, comprising a sense network of the base current of the output power transistor (Q1) that includes a sense transistor (Q2), an error amplifier (OA) for comparing an input bias voltage value with a power control signal, and an input biasing network of the base node of the output power transistor controlled by the output signal of said error amplifier, **characterized in that**

   said sense transistor is coupled as an emitter-follower to the base node of the output power transistor for sensing the base current thereof;

   a control current generator (Ipc) feeds a control current to a β-scaling circuit including a bipolar transistor of the same_type of said output power transistor and through which the control current output by the control current generator is forced for producing a β-scaled control current to be compared with the sensed base current of the output power transistor;

   a first current-to-voltage converting network (11V) is connected to an output of said β-scaling circuit;

   a second current-to-voltage converting network (11V) is connected to the collector node of said emitter-follower sense transistor;
said error amplifier has input nodes connected to said first and second current-to-voltage converting networks, respectively.

2. The control circuit of claim 1, **characterized in that** said current-to-voltage converting networks first and second are referred to the same supply node ($V_{baff}$) of the circuit.

3. The control circuit of claim 1, **characterized in that** said input biasing network comprises a differential stage biased by a reference current generator, a first transistor (Q8) of which has a base driven by the output signal of said error amplifier and the second transistor (Q3) of the differential stage has a base connected to the base node of the output power transistor and the base of said emitter-follower sense transistor is connected to the common collector node of the transistors of said differential stage.

4. The circuit of claim 1, **characterized in that** it comprises a current mirror (Q4, Q5) for mirroring the collector current of said emitter-follower sense transistor through a diode-configured current-to-voltage converting transistor (Q6) having a base connected to a noninverting input node of said error amplifier, to an inverting input node of which is connected the base of a second diode-configured transistor (Q7) through which said β-scaled control current is forced.

5. The circuit of claim 1, wherein said control current generator is a temperature compensated band-gap generator.

6. A method of sensing and limiting the output current of a bipolar transistor power amplifier, comprising a sense network of the base current of the output power transistor that includes a sense transistor, an error amplifier for comparing an input bias voltage value with a power control signal, and an input biasing network of the base node of the output power transistor in function of the output signal of said error amplifier, wherein
the error amplifier of the control loop compares the sensed base current of the output power transistor with a control current that is normalized by scaling it in function of the current gain (β) of a bipolar transistor of the same type of the output power transistor.

7. The circuit of claim 6, wherein said control current that is successively β-scaled is generated by a temperature compensated band gap generator.

**Patentansprüche**

1. Steuerschaltung zur Abtastung und Steuerung des Ausgangsstroms eines bipolaren Transistorleistungsverstärkers, der ein Abtastnetzwerk des Basisstroms des Ausgangsleistungstransistors (Q1), das einen Abtasttransistor (Q2) aufweist, einen Fehlerverstärker (OA) zum Vergleichen eines Eingangsvorspannungswerts mit einem Leistungssteuersignal und ein Eingangsvorspannungsnetzwerk des Basisknotens des Ausgangsleistungstransistors aufweist, das durch das Ausgangssignal des Fehlerverstärkers gesteuert wird, **dadurch gekennzeichnet, daß**
der Abtasttransistor als ein Emitterfolger des Basisknotens des Ausgangsleistungstransistor geschaltet ist, um dessen Basisstrom abzutasten;
ein Steuerstromgenerator (Ipc) einen Steuerstrom in eine β-Skalierungsschaltung einspeist, die einen bipolaren Transistor desselben Typs wie den Ausgangsleistungstransistor aufweist und durch die der durch den Steuerstromgenerator abgegebene Steuerstrom getrieben wird, um einen β-skalierten Steuerstrom zu erzeugen, der mit dem abgetasteten Basisstrom des Ausgangsleistungstransistors verglichen werden soll;
ein erstes Strom-Spannung-Wandlernetzwerk (I/V) mit einem Ausgang der β-Skalierungsschaltung verbunden ist;
ein zweites Strom-Spannung-Wandlernetzwerk (I/V) mit dem Kollektorknoten des Emitterfolger-Abtasttransistors verbunden ist;
der Fehlerverstärker Eingangsknoten aufweist, die mit dem ersten bzw. zweiten Strom-Spannung-Wandlernetzwerk verbunden sind.

2. Steuerschaltung nach Anspruch 1, **dadurch gekennzeichnet, daß** die ersten und zweiten Strom-Spannung-Wandlernetzwerke auf denselben Versorgungsknoten (Vbatt) der Schaltung referenziert werden.

3. Steuerschaltung nach Anspruch 1, **dadurch gekennzeichnet, daß** das Eingangsvorspannungsnetzwerk eine Differenzstufe aufweist, die durch einen Referenzstromgenerator vorgespannt ist, von dem ein erster Transistor (Q8) eine Basis aufweist, die durch das Ausgangssignal des Fehlerverstärkers betrieben wird, und der zweite Transistor (Q3) der Differenzstufe eine Basis aufweist, die mit dem Basisknoten des Ausgangsleistungstransistors verbunden ist, und die Basis des Emitterfolger-Abtasttransistors mit dem gemeinsamen Kollektorknoten der Transistoren der Differenzstufe verbunden ist.

4.  Schaltung nach Anspruch 1, **dadurch gekennzeichnet, daß** sie einen Stromspiegel (Q4, Q5) zur Spiegelung des Kollektorstroms des Emitterfolger-Abtasttransistors durch einen als Diode geschalteten Strom-Spannung-Wandlertransistor (Q6) aufweist, der eine Basis aufweist, die mit einem nichtinvertierenden Eingangsknoten des Fehlerverstärkers verbunden ist, mit dessen invertierenden Eingangsknoten die Basis eines zweiten als Diode geschalteten Transistors (Q7) verbunden ist, durch den der β-skalierte Steuerstrom getrieben wird.

5.  Schaltung nach Anspruch 1, wobei der Steuerstromgenerator ein temperaturkompensierter Bandlückengenerator ist.

6.  Verfahren zum Abtasten und Begrenzen des Ausgangsstroms eines bipolaren Transistorleistungsverstärkers, der ein Abtastnetzwerk des Basisstroms des Ausgangsleistungstransistor, das einen Abtasttransistor aufweist, einen Fehlerverstärker zum Vergleichen eines Eingangsvorspannungswerts mit einem Leistungssteuersignal, und ein Eingangsvorspannungsnetzwerk des Basisknotens des Ausgangsleistungstransistors aufweist, als Funktion des Ausgangssignals des Fehlerverstärkers, wobei
der Fehlerverstärker der Regelschleife den abgetasteten Basisstrom des Ausgangsleistungstransistors mit einem Steuerstrom vergleicht, der normiert wird, indem er als Funktion der Stromverstärkung (β) eines bipolaren Transistors desselben Typs des Ausgangsleistungstransistors skaliert wird.

7.  Verfahren nach Anspruch 6, wobei der Steuerstrom, der fortlaufend β-skaliert wird, durch einen temperaturkompensierten Bandlückengenerator erzeugt wird.

## Revendications

1.  Circuit de commande pour détecter et contrôler le courant de sortie d'un amplificateur de puissance à transistors bipolaires, comprenant un réseau de détection du courant de base du transistor de puissance de sortie (Q1) qui comprend un transistor de détection (Q2), un amplificateur d'erreur (OA) pour comparer une valeur de tension de polarisation d'entrée à un signal de commande de puissance, et un réseau de polarisation d'entrée du noeud de base du transistor de puissance de sortie contrôlé par le signal de sortie de l'amplificateur d'erreur, **caractérisé en ce que** :

    le transistor de détection est couplé en émetteur-suiveur au noeud de base du transistor de puissance de sortie pour détecter son courant de base ;
    un générateur de courant de commande (Ipc) fournit un courant de commande à un circuit de normalisation de β comprenant un transistor bipolaire du même type que le transistor de puissance de sortie et par lequel le courant de commande fourni par le générateur de courant de commande est forcé pour produire un courant de commande normalisé en β pour comparaison au courant de base détecté du transistor de puissance de sortie ;
    un premier réseau de conversion courant-tension (I/V) est connecté à une sortie du circuit de normalisation de β ;
    un deuxième réseau de conversion courant-tension (I/V) est connecté au noeud de collecteur du transistor de détection émetteur-suiveur ;
    l'amplificateur d'erreur a des noeuds d'entrée connectés aux premier et deuxième réseaux de conversion courant-tension, respectivement.

2.  Circuit de commande selon la revendication 1, **caractérisé en ce que** les premier et deuxième réseaux de conversion courant-tension sont référencés par rapport au même noeud d'alimentation (Vbatt) du circuit.

3.  Circuit de commande selon la revendication 1, **caractérisé en ce que** le réseau de polarisation d'entrée comprend un étage différentiel polarisé par un générateur de courant de référence, dont un premier transistor (Q8) a une base pilotée par le signal de sortie de l'amplificateur d'erreur et le deuxième transistor (Q3) de l'étage différentiel a une base connectée au noeud de base du transistor de puissance de sortie et la base du transistor de détection émetteur-suiveur est connectée au noeud de collecteur commun des transistors de l'étage différentiel.

4.  Circuit selon la revendication 1, **caractérisé en ce qu'**il comprend un miroir de courant (Q4, Q5) pour recopier le courant de collecteur du transistor de détection émetteur-suiveur par l'intermédiaire d'un transistor (Q6) de conversion courant-tension monté en diode ayant une base connectée à un noeud d'entrée non-inverseur de l'amplificateur d'erreur, à un noeud d'entrée inverseur duquel est connectée la base d'un deuxième transistor monté en diode (Q7) par l'intermédiaire duquel est forcé le courant de commande normalisé en β.

**5.** Circuit selon la revendication 1, dans lequel le générateur de courant de commande est un générateur à intervalle de bande compensé en température.

**6.** Procédé de détection et de limitation du courant de sortie d'un amplificateur de puissance à transistors bipolaires, comprenant un réseau de détection du courant de base du transistor de puissance de sortie qui comprend un transistor de détection, un amplificateur d'erreur pour comparer une valeur de tension de polarisation d'entrée à un signal de commande de puissance, et un réseau de polarisation d'entrée du noeud de base du transistor de puissance de sortie en fonction du signal de sortie de l'amplificateur d'erreur, dans lequel
l'amplificateur d'erreur de la boucle de commande compare le courant de base détecté du transistor de puissance de sortie à un courant de commande qui est normalisé en lui appliquant un facteur de normalisation en fonction du gain en courant (β) d'un transistor bipolaire du même type que le transistor de puissance de sortie.

**7.** Circuit selon la revendication 6, dans lequel le courant de commande qui est successivement normalisé en β est généré par un générateur à intervalle de bande compensé en température.

**FIG. 1**

**FIG. 2**

**FIG. 3**

**FIG. 4**

**FIG. 5**

**FIG. 6**

**FIG. 7**

**FIG. 8**

## FIG. 9

## FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1326326 A
- US 6853250 B

- US 6271695 B

**Non-patent literature cited in the description**

- **E. Jarvinen.** Bias Circuits for GaAs HBT Power Amplifiers. *IEEE MTT-S Digest,* 2001, 507-510
- **EARL MCCUNE.** Polar modulation and bipolar RF power devices. *BCTM Conferences,* 2005

- **R. A. HEISING.** Modulation Methods. *Proceedings of the IEEE,* May 1962, 896-901
- **E. JARVINENN.** Bias Circuits for GaAs HBT Power Amplifiers. *IEEE MTT-S Digest,* 2001, 507-510